(19) **Europäisches Patentamt**
**European Patent Office**
**Office européen des brevets**

(11) **EP 1 306 680 B1**

(12) **EUROPÄISCHE PATENTSCHRIFT**

(45) Veröffentlichungstag und Bekanntmachung des Hinweises auf die Patenterteilung:
**20.04.2011 Patentblatt 2011/16**

(51) Int Cl.:
***G01R 31/00*** *(2006.01)*

(21) Anmeldenummer: **02023489.4**

(22) Anmeldetag: **21.10.2002**

(54) **Schaltungsanordnung zur Laststromüberwachung**

Circuit for load current monitoring

Circuit pour surveiller le courant de charge

(84) Benannte Vertragsstaaten:
**DE FR GB IT SE**

(30) Priorität: **24.10.2001 DE 10152527**

(43) Veröffentlichungstag der Anmeldung:
**02.05.2003 Patentblatt 2003/18**

(73) Patentinhaber: **Delphi Technologies, Inc.**
**Troy, MI 48007 (US)**

(72) Erfinder:
  • **Giesen, Marko**
    **51588 Nümbrecht (DE)**
  • **Trommer, Frank O.**
    **51588 Nümbrecht (DE)**
  • **Stadler, Peter**
    **57482 Wenden (DE)**

(74) Vertreter: **Denton, Michael John**
**Delphi France SAS**
**Legal Staff**
**64, avenue de la Plaine de France**
**BP 65059 Tremblay en France**
**95972 Roissy CDG Cedex (FR)**

(56) Entgegenhaltungen:
**DE-A- 3 823 922    US-A- 5 894 394**

• **PATENT ABSTRACTS OF JAPAN vol. 2000, no. 12, 3. Januar 2001 (2001-01-03) & JP 2000 253570 A (YAZAKI CORP), 14. September 2000 (2000-09-14) & US 6 459 167 A (YAZAKI CORP) 1. Oktober 2002 (2002-10-01)**
• **PATENT ABSTRACTS OF JAPAN vol. 018, no. 263 (E-1550), 19. Mai 1994 (1994-05-19) & JP 06 038368 A (JIDOSHA KIKI CO LTD), 10. Februar 1994 (1994-02-10)**
• **PATENT ABSTRACTS OF JAPAN vol. 018, no. 629 (E-1637), 30. November 1994 (1994-11-30) & JP 06 244414 A (HITACHI LTD), 2. September 1994 (1994-09-02)**
• **PATENT ABSTRACTS OF JAPAN vol. 018, no. 299 (E-1558), 8. Juni 1994 (1994-06-08) & JP 06 061432 A (NIPPONDENSO CO LTD;OTHERS: 01), 4. März 1994 (1994-03-04)**
• **PATENT ABSTRACTS OF JAPAN vol. 016, no. 402 (P-1409), 25. August 1992 (1992-08-25) & JP 04 134271 A (NEC CORP), 8. Mai 1992 (1992-05-08)**

**Beschreibung**

Die Erfindung betrifft eine Schaltungsanordnung zur Laststromüberwachung für eine über mehrere zueinander parallele elektronische Schalter beaufschlagbare Last.

Zum Ein- und Ausschalten einer Last muss die betreffende Last häufig über mehr als einen elektronischen Schalter, z. B. Mosfets, beaufschlagt werden. Dabei werden zwei oder mehrere solche elektronische Schalter zueinander parallel geschaltet. Soll der Strom überwacht werden, so müssen die elektronischen Schalter eine entsprechende Überwachungsfunktion erfüllen können, d. h. beispielsweise mit einem Stromspiegel versehen oder jeweils als Smart-Mosfet ausgeführt sein.

Da insbesondere im Kraftfahrzeugbereich zunehmend Diagnose- und Schutzfunktionen verwirklicht werden, kommt der Überwachung von Lastströmen eine immer größere Bedeutung zu. Aufgrund dieser Anforderungen sowie infolge des Umstands, dass als Leistungsschalter anstelle der bisher üblichen Relais zunehmend elektronische Schalter eingesetzt werden, steigen die Kosten des für eine jeweilige Last erforderlichen Schaltungsaufwands.

In Patent Abstracts of Japan Bd. 2000, Nr. 12, 3. Januar 2001 (2001-01-03) & JP 2000 253570 A (YAZAKI CORP), 14. September 2000 (2000-09-14), ist ein Steuersystem für einen Elektromotor beschrieben, bei dem parallel zu einem Relais eine der Leistungssteuerung dienende intelligente Einchip-Schutzschalteranordnung vorgesehen ist, die einen MOSFET-Transistor enthält.

Bei einer aus der DE 38 23 922 A bekannten elektronischen Schaltvorrichtung mit Leistungsüberwachung ist eine Stromerfassungsschaltung mit einem Shunt vorgesehen, der mit einer Anordnung von zueinander parallelen Halbleiterschaltungen in Reihe geschaltet ist.

Ziel der Erfindung ist es daher, eine Schaltungsanordnung der eingangs genannten Art zu schaffen, die unter Aufrechterhaltung einer hohen Zuverlässigkeit im Aufbau möglichst einfach gehalten und damit entsprechend kostengünstig ist.

Die Aufgabe wird nach der Erfindung dadurch gelöst, dass lediglich einem Teil und vorzugsweise nur einem der zueinander parallelen elektronischen Schalter eine Stromerfassungs- und/oder -auswerteschaltung zugeordnet ist, um den durch diesen Schalter fließenden Strom zu erfassen bzw. auszuwerten, wobei zumindest eine Stromerfassungsschaltung in dem betreffenden elektronischen Schalter integriert ist.

Die Laststromüberwachung erfolgt somit über lediglich einen Teil und vorzugsweise über nur einen einzigen der zueinander parallelen elektronischen Schalter. Es muss also nur noch ein elektronischer Schalter mit entsprechender Stromerfassungs- bzw. -auswertefunktion eingesetzt werden. Anhand der über diesen einen mit einer entsprechenden Funktion versehenen elektronischen Schalter erhaltenen Ergebnisse sind die erforderlichen Rückschlüsse auf den Laststrom und beispielsweise auch den Zustand der restlichen Schaltungsanordnung möglich. Da die elektronischen Schalter ohne die betreffende Diagnose- und/oder Überwachungsfunktion wesentlich billiger als die elektronischen Schalter mit zugeordneter Diagnose- bzw. Überwachungsfunktion sind, ergibt sich insgesamt eine wesentlich kostengünstigere Schaltungsanordnung. Die Kosteneinsparungen-sind umso größer, je größer die Lastströme sind. Die erfindungsgemäße Schalteranordnung kann im Aufbau äußerst einfach gehalten werden. Ein weiterer Vorteil besteht darin, dass der betreffende Stromüberwachungsschalter einen höheren Einschaltwiderstand als die anderen Schalter besitzen kann. Da die elektronischen Schalter umso teurer sind, je kleiner der Einschaltwiderstand ist, ist es entsprechend kostengünstiger, elektronische Schalter ohne die betreffende Diagnose- bzw. Überwachungsfunktion und mit geringem Einschaltwiderstand anstatt Stromüberwachungsschalter mit geringem Einschaltwiderstand einzusetzen.

Zumindest eine Stromerfassungsschaltung ist in den betreffenden elektronischen Schalter integriert. Der entsprechende elektronische Schalter kann also beispielsweise einen Stromspiegel umfassen oder als so genanntes Smart-Power-Element (SPE), d.h. als intelligentes Power-Modul ausgeführt sein.

Bei einer bevorzugten praktischen Ausführungsform der erfindungsgemäßen Schaltungsanordnung umfassen die zueinander parallelen elektronischen Schalter jeweils einen Mosfet.

Wie bereits erwähnt, kann der elektronische Schalter mit zugeordneter Stromerfassungs- und/oder auswerteschaltung vorteilhafterweise durch ein Smart-Element und insbesondere ein Smart-Power-Element (SPE) gebildet sein. Es ist also insbesondere eine Modulbauweise denkbar, in der insbesondere wenigstens ein Leistungshalbleiter und die für diesen erforderliche Ansteuer- und Schutzschaltung vereint sind. Der betreffende elektronische Schalter kann also insbesondere als Smart-Power-Element (SPE) oder intelligentes Power-Modul (IPM = intelligent power modul) ausgeführt sein.

Umfasst der betreffende elektronische Schalter einen Mosfet, so kann er also insbesondere als so genannter Smart-Mosfet ausgeführt sein.

Der elektronische Schalter mit zugeordneter Stromerfassungs- und/oder -auswerteschaltung besitzt vorzugsweise einen größeren Einschalt- bzw. Drain-Source-Widerstand als die elektronischen Schalter ohne zugeordnete Stromerfassungs- und -auswerteschaltung.

Die betreffende Stromauswerteschaltung kann insbesondere durch einen mit dem betreffenden elektronischen Schalter verbundenen oder in diesem integrierten Mikrocontroller gebildet sein.

Bei einer bevorzugten praktischen Ausführungsform der erfindungsgemäßen Schaltungsanordnung sind die zueinander parallelen elektronischen Schalter über einen Mikrocontroller ansteuerbar.

Die Erfindung wird im folgenden anhand eines Ausführungsbeispiels unter Bezugnahme auf die Zeichnung näher erläutert.

Die einzige Figur der Zeichnung zeigt in schematischer Darstellung eine Schaltungsanordnung 10 zur Laststromüberwachung für eine über mehrere zueinander parallele elektronische Schalter $12_i$ beaufschlagbare Last 14. Bei dem folgenden Ausführungsbeispiel sind vier solche zueinander parallele elektronische Schalter $12_1$- $12_4$ vorgesehen. Grundsätzlich ist jedoch auch eine beliebige andere Anzahl von Schaltern denkbar.

Im vorliegenden Fall ist nur einem der zueinander parallelen elektronischen Schalter $12_i$, hier dem elektronischen Schalter $12_1$, eine Stromerfassungs- und/oder -auswerteschaltung 16, 18 zugeordnet, um den durch diesen Schalter $12_1$ fließenden Strom zu erfassen bzw. auszuwerten.

Die zueinander parallelen elektronischen Schalter $12_i$ sind mit der betreffenden Last 14 in Reihe geschaltet. Der sich ergebende Serienkreis ist an eine Spannungsquelle angeschlossen, bei der es sich beispielsweise um eine Batterie handeln kann. Im vorliegenden Fall ist das schalterseitige Ende des Serienkreises an die positive Klemme ("+ Vbat") und das lastseitige Ende des Serienkreises an die negative Klemme (Masse, "GND") der betreffenden Batterie angeschlossen.

Im vorliegenden Fall sind die zueinander parallelen elektronischen Schalter $12_i$ jeweils durch einen Mosfet gebildet. Dabei sind die Drain-Source-Strecken dieser Mosfets zueinander parallel geschaltet.

Lediglich einer, nämlich der elektronische Schalter $12_1$, ist mit Mitteln 16 versehen, die eine Erfassung des durch diesen elektronischen Schalter $12_1$ fließenden Stromes, d.h. hier Drain-Source-Stromes, ermöglichen. Zur Auswertung des erfassten Stromes ist die dem elektronischen Schalter $12_1$ zugeordnete Stromerfassungsschaltung 16 mit einem Mikrocontroller 18 mit zugeordnetem A/D-Wandler verbunden.

Dabei kann zumindest die Stromerfassungsschaltung 16 in den betreffenden elektronischen Schalter $12_1$ integriert sein.

So kann der elektronische Schalter $12_1$ beispielsweise einen Stromspiegel oder dergleichen umfassen oder durch ein so genanntes Smart-Element und insbesondere ein so genanntes Smart-Power-Element (SPE) gebildet sein. Es ist also insbesondere eine Kombination von Leistungselektronik mit "Intelligenz" und insbesondere eine Modulbauweise denkbar, in der der betreffende Leistungshalbleiter und die für diesen erforderliche Ansteuer- und Schutzschaltungen vereint sind. Es kann also beispielsweise ein so genanntes intelligentes Power-Modul (IPM = intelligent power modul) eingesetzt werden.

Der elektronische Schalter $12_1$ mit zugeordneter Stromerfassungs- und/oder - auswerteschaltung 16, 18 kann einen größeren Einschalt- bzw. Drain-Source-Widerstand $R_{DSein}$ als die elektronischen Schalter $12_2$-$12_4$ ohne zugeordnete Stromerfassungs- und -auswerteschaltung besitzen.

Wie bereits erwähnt, kann zumindest die Stromauswerteschaltung durch einen mit den betreffenden elektronischen Schalter $12_1$ verbundenen oder in diesen integriert Mikrocontroller 18 gebildet sein.

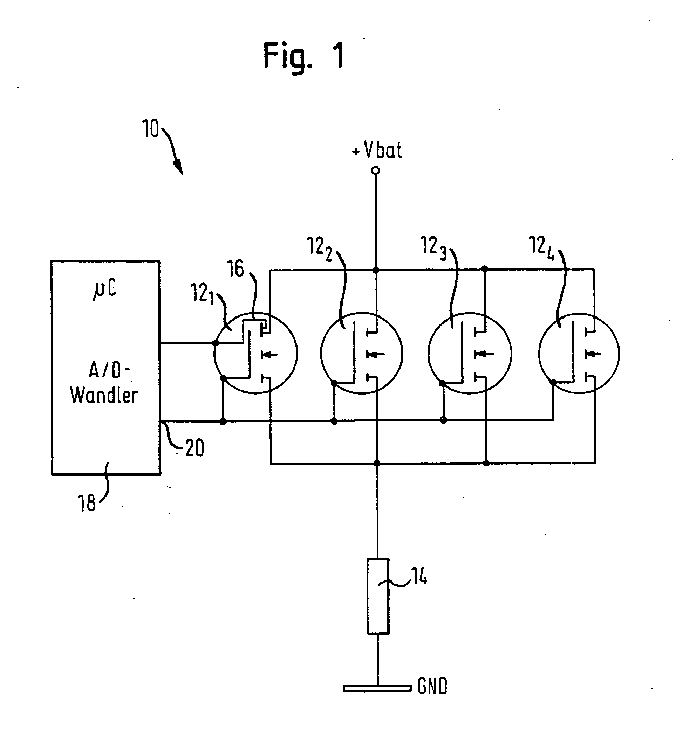

Wie anhand der Figur 1 zu erkennen ist, ist im vorliegenden Fall ein Ausgang 20 des Mikrocontrollers 18 mit den Gate-Elektroden der zueinander parallelen elektronischen Schalter $12_i$ verbunden. Die zueinander parallelen elektronischen Schalter $12_i$ sind also über den Mikrocontroller 18 ansteuerbar.

Im folgenden ist ein Beispiel für eine Stromverteilung zwischen den verschiedenen elektronischen Schaltern $12_1$- $12_4$ angegeben, wobei die nachstehenden Größen betrachtet werden:

| | |
|---|---|
| $I_{Last}$: | Laststrom |
| $I_{RDSein1}$: | Drain-Source-Strom des elektronischen Schalters $12_1$ im eingeschalteten Zustand |
| $U_N$: | Nennspannung |
| $U_{RDsein}$: | an den zueinander parallel geschalteten elektronischen Schaltern anliegende Spannung im eingeschalteten Zustand |
| $R_{DSein1}$: | Drain-Source-Widerstand des elektronischen Schalters $12_1$ im eingeschalteten Zustand |
| $R_{DSein2,3,4}$: | Drain-Source-Widerstand der jeweiligen elektronischen Schalter $12_2$, $12_3$ und $12_4$ im eingeschalteten Zustand |

Für einen Teil der zuvor genannten Größen können die betreffenden Werte insbesondere den Datenblättern der betreffenden Mosfets entnommen werden. Dabei handelt es sich beispielsweise um die Größen $U_N$ und $R_{DSeini}$. Gemessen werden kann insbesondere die Größe $I_{RDSein1}$ des elektronischen Schalters $12_1$, dem dazu eine entsprechende Stromerfassungs- bzw. -auswerteschaltung 16, 18 zugeordnet ist. Die anderen Größen können aus der gemessenen Größe sowie den z.B. aus den Datenblättern erhaltenen Angaben abgeleitet werden.

Ausgehend von beispielsweise den folgenden Werten

$I_{Last}$ = 30 A
$U_N$ = 12 V

$R_{DSein1}$ = 100 mOhm (Strommessschalter $12_1$)
$R_{DSein2,3,4}$ = 10 mOhm (normale Schalter $12_2$- $12_4$)
ergibt sich folgendes:

$$U_{RDSein} = I_{Last} \ * \ \cfrac{1}{\cfrac{1}{R_{DSein1}} + \cfrac{1}{R_{DSein2}} + \cfrac{1}{R_{DSein3}} + \cfrac{1}{R_{DSein4}}}$$

$$U_{RDSein} = 30A \ * \ 3{,}22 \ m\Omega = 96{,}7 \ mV$$

$$I_{RDSein1} = \frac{U_{RDSein}}{R_{DSein1}} = 0{,}967 \ A \qquad I_{RDSein2,3,4} = \frac{U_{RDSein}}{R_{DSein2,3,4}} = 9{,}67 \ A$$

(für jeden weiteren Schalter)

**Bezugszeichenliste**

| | |
|---|---|
| 10 | Schaltungsanordnung |
| $12_i$ | elektronsicher Schalter |
| 14 | Last |
| 16 | Stromerfassungsmittel |
| 18 | Mikrocontroller |
| 16, 18 | Stromerfassungs- und/oder -auswerteschaltung |
| 20 | Ausgang |

**Patentansprüche**

1. Schaltungsanordnung (10) zur Laststromüberwachung für eine über mehrere zueinander parallele elektronische Schalter ($12_i$) beaufschlagbare Last (14), wobei lediglich einem Teil und vorzugsweise nur einem ($12_1$) der zueinander parallelen elektronischen Schalter ($12_i$) eine Stromerfassungs- und/oder -auswerteschaltung (16, 18) zugeordnet ist, um den durch diesen Schalter ($12_1$) fließenden Strom zu erfassen bzw. auszuwerten, **dadurch gekennzeichnet, dass** zumindest eine Stromerfassungsschaltung (16) in dem betreffenden elektronischen Schalter ($12_1$) integriert ist.

2. Schaltungsanordnung nach Anspruch 1,
**dadurch gekennzeichnet ,**
**dass** die Stromerfassungsschaltung (16) einen Stromspiegel umfasst.

3. Schaltungsanordnung nach einem der vorhergehenden Ansprüche,
**dadurch gekennzeichnet ,**
**dass** die zueinander parallelen elektronischen Schalter ($12_i$) jeweils einen Mosfet umfassen.

4. Schaltungsanordnung nach einem der vorhergehenden Ansprüche,
**dadurch gekennzeichnet ,**
**dass** der elektronische Schalter ($12_1$) mit zugeordneter Stromerfassungs- und/oder -auswerteschaltung (16, 18) durch ein Smart-Element und insbesondere ein Smart-Power-Element gebildet ist.

5. Schaltungsanordnung nach einem der vorhergehenden Ansprüche,
**dadurch gekennzeichnet ,**

4

**dass** der elektronische Schalter ($12_1$) mit zugeordneter Stromerfassungs- und/oder-auswerteschaltung (16, 18) durch einen Smart-Mosfet gebildet ist.

6. Schaltungsanordnung nach einem der vorhergehenden Ansprüche,
   **dadurch gekennzeichnet ,**
   **dass** der elektronische Schalter ($12_1$) mit zugeordneter Stromerfassungs- und/oder -auswerteschaltung (16, 18) einen größeren Einschalt- bzw. Drain-Source-Widerstand ($R_{DSein}$) als die elektronischen Schalter ($12_2$ - $12_4$) ohne zugeordnete Stromerfassungs- und - auswerteschaltung besitzt.

7. Schaltungsanordnung nach einem der vorhergehenden Ansprüche,
   **dadurch gekennzeichnet ,**
   **dass** zumindest die Stromauswerteschaltung durch einen mit dem betreffenden elektronischen Schalter ($12_1$) verbundenen oder in diesem integrierten Mikrocontroller (18) gebildet ist.

8. Schaltungsanordnung nach einem der vorhergehenden Ansprüche,
   **dadurch gekennzeichnet ,**
   **dass** die zueinander parallelen elektronischen Schalter ($12_i$) über einen Mikrocontroller (18) ansteuerbar sind.

**Claims**

1. Circuit arrangement (10) for load current monitoring for a load (14) subjectable over several parallel-connected electronic switches ($12_i$),
   wherein
   only one part and preferably only one ($12_1$) of the parallel-connected electronic switches ($12_i$) is provided with a current detection and/or evaluation circuit (16,18) to detect and/or to evaluate the current flowing through said switch ($12_1$), **characterized in that** at least one current detection circuit (16) is integrated in the respective electronic switch ($12_1$).

2. Circuit arrangement according to claim 1,
   **characterized in that**
   the current detection circuit (16) includes a current mirror.

3. Circuit arrangement according to one of the preceding claims,
   **characterized in that**
   the parallel-connected electronic switches ($12_i$) each include a Mosfet.

4. Circuit arrangement according to one of the preceding claims,
   **characterized in that**
   the electronic switch ($12_1$) with associated current detection and/or evaluation circuit (16,18) is formed by a Smart element and in particular a Smart power element.

5. Circuit arrangement according to one of the preceding claims,
   **characterized in that**
   the electronic switch ($12_1$) with associated current detection and/or evaluation circuit (16,18) is formed by a Smart Mosfet.

6. Circuit arrangement according to one of the preceding claims,
   **characterized in that**
   the electronic switch ($12_1$) with associated current detection and/or evaluation circuit (16,18) has a larger start-up or drain source resistance ($R_{DSein}$) than the electronic switches ($12_2$ - $12_4$) without associated current detection and evaluation circuit.

7. Circuit arrangement according to one of the preceding claims,
   **characterized in that**
   at least the current evaluation circuit is formed by a microcontroller (18) connected or integrated with the respective electronic switch ($12_1$).

8. Circuit arrangement according to one of the preceding claims,
**characterized in that**
the parallel-connected electronic switches ($12_i$) are controllable through a microcontroller (18).

## Revendications

1. Agencement de circuit (10) pour la surveillance du courant de charge pour une charge (14) susceptible d'être alimentée via plusieurs commutateurs électroniques ($12_i$) parallèles les uns aux autres, dans lequel un circuit de détection et/ou d'évaluation de courant (16, 18) est associé à uniquement une partie et de préférence seulement un ($12_1$) des commutateurs électroniques ($12_i$) parallèles les uns aux autres, afin de détecter ou d'évaluer le courant qui s'écoule à travers ce commutateur ($12_1$),
**caractérisé en ce qu'**au moins un circuit de détection de courant (16) est intégré dans le commutateur électronique ($12_1$) concerné.

2. Agencement de circuit selon la revendication 1,
**caractérisé en ce que** le circuit de détection de courant (16) comprend un miroir de courant.

3. Agencement de circuit selon l'une des revendications précédentes,
**caractérisé en ce que** les commutateurs électroniques ($12_i$) parallèles les uns aux autres comprennent chacun un transistor MOSFET.

4. Agencement de circuit selon l'une des revendications précédentes,
**caractérisé en ce que** le commutateur électronique ($12_1$) avec circuit de détection et/ou d'évaluation de courant (16, 18) associé est formé par un élément intelligent et en particulier un élément de puissance intelligent.

5. Agencement de circuit selon l'une des revendications précédentes,
**caractérisé en ce que** le commutateur électronique ($12_1$) avec circuit de détection et/ou d'évaluation de courant (16, 18) associé est formé par un transistor MOSFET intelligent.

6. Agencement de circuit selon l'une des revendications précédentes, **caractérisé en ce que** le commutateur électronique ($12_1$) avec circuit de détection et/ou d'évaluation de courant (16, 18) associé possède une résistance d'entrée ou résistance drain-source ($R_{DSin}$) plus élevée que les commutateurs électroniques ($12_2$-$12_4$) sans circuit de détection et/ou d'évaluation de courant associés.

7. Agencement de circuit selon l'une des revendications précédentes,
**caractérisé en ce que** le circuit d'évaluation de courant au moins est formé par un microcontrôleur (18) connecté au commutateur électronique (121) concerné ou intégré dans celui-ci.

8. Agencement de circuit selon l'une des revendications précédentes,
**caractérisé en ce que** les commutateurs électroniques (12i) parallèles les uns aux autres sont susceptibles d'être pilotés via un microcontrôleur (18).

# Fig. 1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- JP 2000253570 A
- DE 3823922 A

### In der Beschreibung aufgeführte Nicht-Patentliteratur

- *Patent Abstracts of Japan,* 03. Januar 2001, vol. 2000 (12